# EUROPEAN PATENT SPECIFICATION

(11) **EP 3 694 704 B1**
(45) Date of publication and mention of the grant of the patent: **27.11.2024**
(21) Application number: 18789704.6
(22) Date of filing: 09.10.2018
(51) Int. Cl.: B31D 1/02

(54) **METHOD AND ARRANGEMENT FOR PRODUCING A LABEL WITH INTEGRATED ELECTRICALLY CONDUCTIVE PATTERN**
VERFAHREN UND ANORDNUNG ZUR HERSTELLUNG EINES ETIKETTS MIT INTEGRIERTEM ELEKTRISCH LEITENDEM MUSTER
PROCÉDÉ ET AGENCEMENT DE PRODUCTION D'UNE ÉTIQUETTE À MOTIF ÉLECTROCONDUCTEUR INTÉGRÉ

(30) Priority: 13.10.2017 SE 1751265
(43) Date of publication of application: 19.08.2020
(73) Proprietor: Digital Tags Finland Oy, 33100 Tampere (FI)
(72) Inventor: HUHTASALO, Lauri, 33200 Tampere (FI); MAIJALA, Juha, 02330 Espoo (FI)
(74) Representative: Papula Oy
(86) International application number: PCT/IB2018/057812
(87) International publication number: WO 2019/073380

(56) References cited:
- FR-A1- 2 775 533
- FR-B1- 2 775 533
- US-A1- 2008 117 056
- US-A1- 2009 294 534
- US-A1- 2016 243 577

## Description

### Technical field of the invention

The present invention is related to a method and an arrangement for production of labels with integrated electrically conductive patterns, such as integrated antennas, and in particular production of smart labels and RFID-labels.

### Background

In recent years, new methods of producing printed electronics have been developed, allowing forming of conductive electrical patterns on substrates such as paper and plastics, avoiding the problems of etching and the like used in silk screen printing of printed circuit boards (PCB). Such new methods are e.g. discussed in WO 2013/113995, WO 2016/189446, WO 2009/135985 and WO 2008/006941.

One common use of printed electronics is as integrated inserts in labels, e.g. in so-called smart labels. A smart label is a flat configured transponder under a conventional print-coded label, and includes a chip and an antenna. The labels are often made of paper, fabric or plastics, and are normally prepared as a paper roll with the RFID inlays laminated between a rolled carrier and a label media for use in specially designed printer units. Smart labels offer advantages over conventional barcode labels, such as higher data capacity, possibility to read and/or write outside a direct line of sight, and the ability to read multiple labels or tags at one time.

However, despite the progress made in production of printed electronics, production of smart labels and other types of labels having integrated electrical patterns is still cumbersome and costly.

Conventional RFID/smart label production processes use separate equipment to produce RFID antennas and to assemble microchips onto the antennas. RFID transponders are then forwarded to a label converting facility, and are then in various ways attached and integrated in the labels. Such a process is e.g. disclosed in US 2007/0181247, in which the label stock is delaminated, RFID transponders are inserted between the delaminated layers, and the layers are again re-laminated. This process is in itself complicated and costly, and is difficult to control with sufficient accuracy.

Thus, the overall process to form RFID labels today is very costly, and requires a large number of separate equipment to produce antennas, inlays and the final label, resulting in large capital expenditure and floor space requirements. The many different steps used also makes the production difficult to control efficiently, and also leads to complicated production setups and handling. Further, large work-in-progress storages are needed, and the overall lead-time is long.

Further, production of a non-laminated label is disclosed in US 2008/0117056, teaching the provision of an opening in a release liner for mounting of an interposer in a roll-to-roll process. US 2009/0294534 and FR 2775533 disclose laminated labels in which RDIF chips are arranged within cutout portions in intermediate layers.

There is therefore a need for a method and arrangement for more efficient production of labels with integrated electrically conductive patterns, such as integrated antennas, and in particular for more efficient production of smart labels and RFID-labels.

### Summary

It is therefore an object of the present invention to provide a method and an arrangement for forming labels with integrated electrically conductive patterns which at least alleviates the above-discussed problems.

This object is obtained by means of a method and a production system in accordance with the appended claims.

According to a first aspect of the invention there is provided a method for forming a label with an electrically conductive pattern in a roll-to-roll process, comprising the steps:
providing a first roll of a face material web;
forming a conductive material in a pattern corresponding to said electrically conductive pattern on a surface of the face material web;
providing a second roll of a backing material web;
applying a layer of adhesive on a surface of the backing material web;
forming holes in the backing material, before or after said application of adhesive;
bringing the backing material web and the face material web together, so that the conductive material and the adhesive are facing each other, between the face material web and the backing material web, and whereby the holes are arranged overlying dedicated contact areas formed in the electrically conductive pattern;
laminating the face sheet material with the electrically conductive pattern and the backing sheet material with the adhesive together; and
re-winding the laminated web on a third roll.

The invention is based on the surprising realization of the present inventors that a label converting process is in many aspects similar to methods for producing printed electronics. Thus, by means of the present invention, an electrically conductive pattern, such as an antenna for an RFID transponder, can be formed as an integral part of a conventional label converting process. This enables the production of labels with integrated electrically conductive patterns in a much faster and more cost-efficient way. It also enables enhanced control of the entire process, since it is all made at once, and in a single production line. There is therefore no longer a need to form the electrically conductive patterns separately, and also no need for the difficult and cumbersome process of connecting the electrically conductive patterns onto already produced labels.

The present method integrates a label converting/manufacturing process and the process for forming the electrically conductive pattern, and optionally also the process of providing an integrated circuit, such as an RFID chip, into a single production process. Hereby, many steps that are conventionally performed separately in each of these processes, such as insertion of web rolls, threading of webs through the production path, re-winding, etc, can hereby be performed only once, which makes the process much more cost and time efficient. It also reduces the overall need for manufacturing machinery and production space.

By use of the present invention, labels with integrated electrically conductive patterns can be produced directly at a single facility, such as in production facilities of label converting companies. Hereby, the transports between various subcontractors and the like are minimized. It also reduces the needs for intermediate stocks, and the overall need for stock and storage can be significantly reduced. Further, the producer is afforded a greater control of the production process and can more easily control the quality of the end product, and can also introduce necessary modifications, etc.

The method and arrangement of the present invention is a roll-to roll process, in which input rolls are provided at one end and output rolls are received at the other. Hereby, the process is highly suitable for fully automated production.

Further, the output, labels with integrated electrically conductive patterns, may easily be fitted with a chip, arranged within the hole formed in the backing material web, for forming e.g. smart labels and RFID labels. The step of adding and connecting such chips to the labels can be provided as a further step in the same production line, either prior to lamination or after lamination, or can be arranged as separate production line.

The face material web preferably comprises at least one of: paper, board, polymer film, textile and non-woven material.

The forming of the conductive material in a pattern can be made in various ways. For example, the forming of the conductive pattern can be made by printing with silver ink, i.e. ink comprising conductive silver particles. The solvent can then be evaporated by means of heating at an elevated temperature, by use of photonic curing, or the like. The forming of the conductive pattern can also be made by first providing a conductive layer on the web, and the removing or forming this conductive layer into the desired conductive pattern, e.g. by means of grinding, cutting, or the like. This can e.g. be made in the way disclosed in EP 1 665 912 and WO 2005/027599, said documents hereby being incorporated in their entirety by reference.

In a preferred embodiment, the conductive material in a pattern comprise: transferring a conductive material in a pattern corresponding to said electrically conductive pattern to a surface of the face material web; and heating the conductive material to a temperature exceeding a characteristic melting temperature of the conductive material.

The conductive material is preferably in the form of electrically conductive solid particles. The transferring of conductive material to the face material web may e.g. comprise direct printing of electrically conductive particles as a part of a compound that contains, in addition of the electrically conductive solid particles, a fluid or gelatinous substance. However, the electrically conductive solid particles may also be in the form of dry powder. Further, an adhesive area may be created on the surface of the face material web prior to transfer of the particles.

The heating is preferably made with a non-contacting heating method. The heating of the conductive material to a temperature exceeding a characteristic melting temperature of the conductive material results in a melting and solidification of the conductive material. This may in itself be sufficient to form the electrically conductive pattern. However, the method may also comprise a step of applying a pressure onto the heated conductive material prior to lamination. This pressure may be applied by a nip, and preferably the surface temperature of the nip is lower than the characteristic melting temperature. This pressure is preferably applied relatively soon after the heating, so that the material still remains in a melted or almost melted state. Hereby, the pressure will cause the previously melted material to solidify in the form of an essentially continuous, electrically conductive layer that covers an area on the face material web corresponding to the intended electrically conductive pattern. The electrically conductive pattern produced in this way has a good adhesion with the substrate, high peeling strength, and good continuity of conductivity.

The "characteristic melting temperature" here means for example that if the conductive particles are composite particles where two or more constituents remain separate in different particles and/or even within a single particle, the characteristic melting temperature is the temperature at which such a constituent melts that has a predominant effect on the creation of cohesion within the melt coming from a plurality of molten particles. Another way to define a "characteristic melting temperature" is to say that it is a temperature at and/or above which the substance in question begins to behave predominantly as a more or less viscous fluid. If the conductive particles are homogeneous in composition and consist only of one metal or alloy that has a well-defined melting temperature, the characteristic melting temperature is the melting temperature of that metal or alloy.

The transfer of the conductive particles and the curing and solidification may in particular be made in the way disclosed in one or several of WO 2013/113995, WO 2009/135985, WO 2008/006941 and WO 2016/189446, all of said documents hereby being incorporated in their entirety by reference.

Curing may be effected by heating, or by a combination of heat and pressure. In case both heat and pressure are used, the curing may be referred to as sintering. During curing, the transferred conductive material, e.g. in the form of particles, is convert into a continuously conducting pattern affixed to the web substrate. The sintering is preferably carried out in a nip comprising two opposing nip members, at least one of which may be heatable, between which the web is fed. Additionally, or alternatively, the curing may also comprise irradiation of the conductive material, e.g. with UV radiation, e-beam radiation or the like.

The backing material preferably comprises at least one of: paper, board, polymer film, textile and non-woven material. The backing material may be of the same type as the facing sheet material, but may alternatively be of a different type.

The adhesive is preferably a pressure sensitive adhesive.

The lamination is preferably made by compressing the face material web with the electrically conductive pattern and the backing material web with the adhesive together by a lamination nip.

The holes in the backing material web may e.g. be formed by punching or die cutting.

The holes may be formed and arranged to receive a chip or the like therein. Thus, chip may hereby become connected to the dedicated contact areas formed in the electrically conductive pattern.

The method may further comprise the step of inserting a chip into the hole and conductively attaching the chip to the dedicated contact areas. This step may be provided as an integrated part of the procedure, and be performed prior to the re-winding of the laminated web on the third roll. This step could be performed prior to lamination of the face material web and the backing material web. However, it may also be performed during or after lamination. Alternatively, this step may also be made in a separate procedure after re-winding. In such an alternative, the web of the third roll will be inserted into a new production line, where the chips are mounted.

The electrically conductive pattern is preferably arranged to form an antenna, and most preferably a dipole antenna.

The chip may be an integrated circuit for forming an RFID transponder together with the antenna formed by the electrically conductive pattern. The RFID transponder may be either passive, i.e. powered by a reader's electromagnetic field, or active, i.e. powered by an onboard battery.

According to another aspect of the present invention, there is provided an arrangement for forming a label with an integrated electrically conductive pattern in a roll-to-roll process, comprising:
a first input station for receiving a first roll of a face material web;
a pattern forming station for forming a conductive material in a pattern corresponding to said electrically conductive pattern on a surface of the face material web; a second input station for receiving a second roll of a backing material web;
an adhesive applicator providing a layer of adhesive on a surface of the backing material web;
a hole forming station for forming holes in the backing material web, before or after said application of adhesive;
a laminating nip laminating the face material web and the backing material web together, with the electrically conductive pattern and the adhesive arranged between the face material web and the backing material web, and with the holes arranged overlying dedicated contact areas formed in the electrically conductive pattern; and
a re-winding station for re-winding the laminated sheet on a third roll.

By this aspect of the invention, similar advantages and preferred features and embodiments as discussed above, in relation to the first aspect of the invention, are obtainable.

The arrangement is preferably realized based on a conventional label converting machine, but with added equipment and stations to form the electrically conductive pattern, and possibly also for punching through-holes in the backing material web, and/or for connecting an integrated circuit, such as an RFID chip, to the electrically conductive pattern.

As discussed above, the forming of the conductive pattern can be made in various ways. According to one embodiment, the pattern forming station comprises a particle handler for transferring a conductive material in a pattern corresponding to the electrically conductive pattern to a surface of the face material web; and a heater for heating the conductive material to a temperature exceeding a characteristic melting temperature of the conductive material.

These and other aspects of the invention will be apparent from and elucidated with reference to the embodiments described hereinafter.

### Brief description of the drawings

For exemplifying purposes, the invention will be described in closer detail in the following with reference to embodiments thereof illustrated in the attached drawings, wherein:
Fig 1 is a schematic illustration of a production line for producing labels with electrically conductive patterns, such as antenna elements, in accordance a method and system of an embodiment of the present invention;
Fig 2 is a schematic illustration of a production line for using the output labels of Fig 1 to produce RFID labels, in accordance with an embodiment of the present invention; and
Fig 3 is a schematic, cross-sectional illustration of the materials obtained by the different steps of the method and system disclosed in Figs. 1 and 2.

### Detailed description of preferred embodiments

In the following detailed description preferred embodiments of the invention will be described. However, it is to be understood that features of the different embodiments are exchangeable between the embodiments and may be combined in different ways, unless anything else is specifically indicated. It may also be noted that, for the sake of clarity, the dimensions of certain components illustrated in the drawings may differ from the corresponding dimensions in real-life implementations of the invention, such as the thickness of various layers, etc.

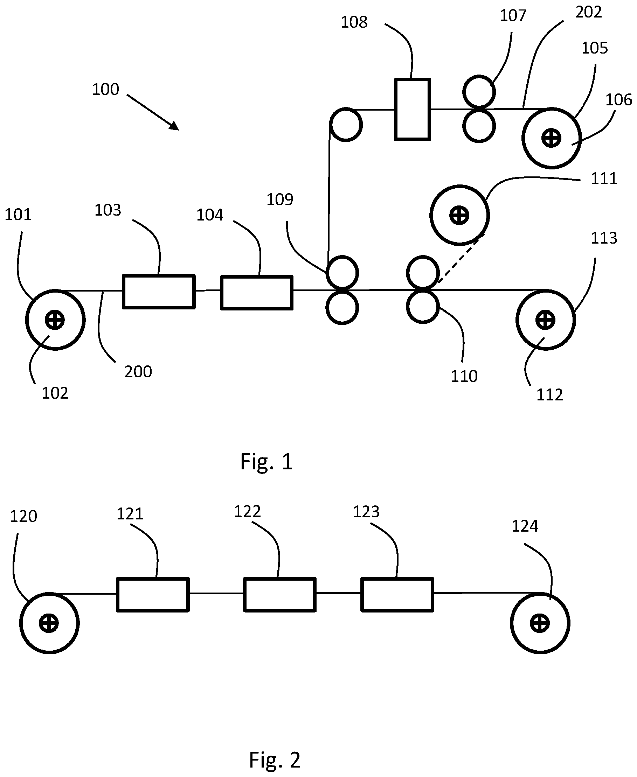

With reference to Fig 1, a production method and arrangement for forming labels with therein integrated electrically conductive patters, such as antennas, will now be discussed in more detail.

The system 100 comprises a first input or unwind station 101, provided with a reel holder for receiving rolls 102 of a face material web 200. The face material web can e.g. be paper.

The face material is preferably a fibrous web, and can be of any of a wide variety of materials, widths and thicknesses. Paper and polymer films (plastics) are suitable, but other similar non-conductive surfaces may be also used. The face material may also be coated, and a multilayered web may also be used.

The face material web is transferred to a particle handler 103, arranged to transfer a conductive material in a pattern onto a surface of the face material web. The pattern corresponds to the electrically conductive pattern to be provided in the label.

Prior to the particle transfer, an adhesion area may be formed in the surface of the web, as is per se known in the art, in order to maintain the particles in the desired place until melting and pressing has occurred. However, depending on the materials used, etc, this step may also be omitted. The adhesion area may be formed in correspondence with the intended pattern for the electrically conductive pattern to be formed, and may e.g. be formed by dispersive adhesion (i.e. gluing) or electrostatic adhesion. This may e.g. be performed by an adhesive printing or lacquering section (not separately shown) that is configured to spread an adhesive or lacquer onto the substrate to create an adhesion area of predetermined form, or by an electric charger section that is configured to create a spatial distribution of static electric charge in the web material to create an adhesion area of predetermined form. However, additionally or alternatively, the particles may directly be transferred onto the web in correspondence with the electrically conductive pattern to be formed.

It is also possible to transfer electrically conductive solid particles onto the surface of the substrate with a method that involves simultaneously creating the necessary adhesion. For example, the electrically conductive solid particles may come as a part of a compound that contains, in addition to the electrically conductive solid particles, a fluid or gelatinous substance that has adhesive properties. In that case, the preparatory creation of adhesion areas may be omitted.

The conductive material is then cured to form a solidified, more compact pattern. This can e.g. be made by application of heat with a heater 104. Hereby, the conductive material is preferably heated to a temperature exceeding a characteristic melting temperature of the conductive material.

The heating is preferably a non-contacting heating, which reduces the risk of smearing or unwanted macroscopic changes in the spatial distribution of conductive material on the surface of the web. However, heating methods that are contacting may also be used. Especially if heating is made with low or very low contact pressure, it may well have the same advantageous non-smearing characteristics. As a result of the heating, a melt is created.

Non-contacting heating may e.g. be obtained by infrared radiation, laser heating, or heating with other types of radiation, inductive heating, streaming with hot gas, etc. However, heating may also be made by bringing the substrate web or the conductive material into contact with a heated body, such as a heated nip.

The heating of the conductive material to a temperature exceeding a characteristic melting temperature of the conductive material results in a melting and solidification of the conductive material. This may in itself be sufficient to form the electrically conductive pattern, in particular if the heating also involves contacting the transferred particles with pressure.

However, the method may also comprise a step of applying a pressure onto the heated conductive material, subsequent to the heating but prior to lamination. This pressure may be applied by a nip (not shown), and preferably the surface temperature of the nip is lower than the characteristic melting temperature. This pressure is preferably applied relatively soon after the heating, so that the material still remains in a melted or almost melted state. Hereby, the pressure will cause the previously melted material to solidify in the form of an essentially continuous, electrically conductive layer that covers an area on the face material web corresponding to the intended electrically conductive pattern.

The nip may be a non-heated nip. However, preferably, the nip is heated to a temperature only somewhat lower than the characteristic melting temperature, such as 30-60 degrees C lower. This ensures for example that the melt will not solidify prematurely, before it would become pressed against the substrate. The nip will cause the previously molten material of the originally solid electrically conductive particles to solidify again, but this time not in the form of separate particles but in the form of an essentially continuous, electrically conductive layer, arranged in the predetermined pattern.

However, in other embodiments, the nip temperature may be equal or almost equal to the characteristic melting temperature of the used electrically conductive material.

Further, as already discussed, the pressing step may in some embodiments be omitted. Still further, other nips used in the process, e.g. the lamination nip discussed in more detail below, may be arranged to provide a pressure sufficient also for solidifying the melted particles, even without any additional pressing step prior to lamination.

The transfer of the conductive particles and the curing and solidification may in particular be made in the way disclosed in one or several of WO 2013/113995, WO 2009/135985, WO 2008/006941 and WO 2016/189446, all of said documents hereby being incorporated in their entirety by reference.

The electrically conductive solid particles may be of any metal, and may e.g. be of pure metal. However, the particles are preferably formed of alloys, and most preferably non-eutectic alloys. In particular, it is preferred to use particles of metallic compounds that are - or resemble - so-called low temperature solders. The alloys preferably comprise tin and bismuth.

A non-limiting example list of such metallic compounds includes (indicated percentages are weight percentages):
- tin / silver (3.43 percent) / copper (0.83 percent)
- tin / silver (2-2.5 percent) / copper (0.8 percent) / antimony (0.5-0.6 percent)
- tin / silver (3.5 percent) / bismuth (3.0 percent)
- tin / zink (10 percent)
- tin / bismuth (35-58 percent)
- tin / indium (52 percent)
- bismuth (53-76 percent) / tin (22-35 percent) / indium (2-12 percent)
- tin (35-95 percent) / bismuth (5-65 percent) / indium (0-12 percent).

At room pressure, the first four listed examples melt between 180 and 220 degrees centigrade, while the four last-mentioned may melt at significantly lower temperatures, even below 100 degrees centigrade.

Preferably, the particle-type conductive matter consists essentially of metal or metal alloy particles. The metal or metal alloy preferably has an atmospheric-pressure characteristic melting temperature of less than 300 degrees C, and more preferably less than 250 degrees C, and most preferably less than 200 degrees C, such as in the range 50-250 deg. C, or preferably within the range 100-200 deg. C, which makes the method suitable, for example, for conventional paper, the physical properties of which may permanently change at too high temperatures. Suitable metals include, e.g. tin, bismuth, indium, zinc, nickel, or similar, used as single metals or in combinations. For example, tin-bismuth, tin-bismuth-zinc, tin-bismuth-indium or tin-bismuth-zinc-indium in different ratios may be used. In tin-containing alloys, the ratio of tin in the alloy is preferably 20 - 90 wt- percent, and most preferably 30 - 70, wt- percent of the total weight of the components in the alloy.

One possible embodiment for transferring the conductive material to the substrate web has been discussed in detail above. However, other ways of obtaining this conductive material transfer are also feasible. The material transfer may e.g. be obtained by:
- Transfer roll having electrodes, which are in different potential than the particle deposited on the surface of the transfer roll.
- Electrofotographic transfer, where the particles may be deposited in a solvent. The solvent is evaporated or absorbed by the substrate (in particular paper or board), whereafter the sintering is carried out for (almost) dry particles.
- Screen printing, where particles in liquid form (i.e. where particles are arranged in solvent or suspension) are transferred to the substrate through a web-like screen means (cloth or metal) or through a stencil.
- Gravure printing, flexographic printing, offset printing, ink-jet printing or the like of particles dissolved or suspended in carrier medium.

Further, other ways of forming the conductive material in a pattern can also be used. For example, the forming of the conductive pattern can be made by printing with silver ink, i.e. ink comprising conductive silver particles. The solvent can then be evaporated by means of heating at an elevated temperature, by use of photonic curing, or the like. The forming of the conductive pattern can also be made by first providing a conductive layer on the web, and the removing or forming this conductive layer into the desired conductive pattern, e.g. by means of grinding, cutting, or the like.

At a second input or unwind station 105, a second roll 106 of a backing material web 202 is provided on a second reel holder. The backing material web may e.g. be a paper material, and can e.g. be provided with a silicone surface, i.e. a siliconized paper. However, other types of fibrous or non-fibrous materials may also be used, such as polymer films (plastics). The backing material web can be of any of a wide variety of materials, widths and thicknesses. However, the width preferably corresponds to the width of the face material web.

The backing material web is led through an adhesive applicator 107 providing a layer of adhesive on a surface of the backing material web. The adhesive may e.g. be a pressure sensitive adhesive (PSA) or a pressure sensitive hot melt adhesive.

Thereafter, the web may be led through a punch station 108 or the like, where through holes are formed in the backing material web. The holes may also be formed by die-cutting or the like. The through holes are preferably sized and shaped to receive an integrated circuit intended to be connected to the electrically conductive patterns being formed on the face material web.

The two webs, the face material web with the electrically conductive pattern and the backing material web with the adhesive layer, are then brought together, and laminated in a lamination nip 109. The webs are brought together so that the conductive material and the adhesive are facing each other, between the face material web and the backing material web. The lamination nip 109 exerts a pressure towards the webs, thereby effecting lamination. However, the lamination nip may also optionally be a heated nip, thereby also effecting lamination by additional heating.

In case holes have been formed in the backing material web, the webs are preferably brought together in such a way that the holes are arranged overlying dedicated contact areas formed in the electrically conductive pattern.

After lamination, a die cutter 110 or the like may be provided in order to separate the labels from each other, and to provide the desired shape and dimensions of the labels. The die cutting station may e.g. be used to perforate the web, or completely cut through the web material along cutting lines. The die cutting station is preferably held in registration with the insertion stations so that the laminated label web may be cut without cutting through an electrically conductive pattern. The die cutting station may comprise cutting elements, e.g. in the form of one or more rotary die or other types of tooling for cutting or perforating used for forming labels or tags. The die cutting station may also comprise a monitor or sensor to identify the location of the electrically conductive pattern, to ensure that cutting does not occur over the electrically conductive patterns.

Further, a waste matrix removal station 110 may be provided, and the removed matrix may be rolled onto a waste roll 111.

The finished, laminated web may then be re-winded onto a third roll 113 at a re-winding station 112.

The labels may also be provided with an additional layer of adhesive on an outer surface, useable to adhere the label to packages, containers and the like. In that case, the labels may further comprise an easily removable release liner to cover the adhesive.

The labels may further comprise printed information, in the form of text, digits, bar codes, etc. To this end, the system may further comprise a printing station, e.g. for printing the face material web. The printing station (not shown) can e.g. be arrange prior to the particle handler 103. However, the roll 102 of face material web may also comprise pre-printed label stock. The printing can be made by flexographic printing, off-set printing or any other printing method.

The re-winding station 113 may also comprise post-processing means that are configured to post-process the final web, for example by cooling, removing static electric charge, coating, evaporation of volatile components of substances present within or on the web, or the like.

One or more tensioning devices (not shown) may also be provided along the production line, to control the tension of the webs, as is per se known in the art.

The output, labels with integrated electrically conductive patterns, may easily be fitted with an integrated circuit (IC), such as a chip, for forming e.g. smart labels and RFID labels. The step of adding and connecting such circuits/chips to the labels can be provided as a further step in the same production line, or can be arranged as separate production line.

In one embodiment, schematically illustrated in Fig. 2, a separate production line for inserting and attaching integrated circuits/chips in pre-produced labels is illustrated.

Here, a first input or unwind station 120 is provided, arranged to receive a roll of pre-produced labels having integrated electrically conductive patterns. This roll may e.g. be the third roll 112 resulting from the process discussed in relation to Fig. 1, containing the web or pre-produced labels.

In a first step, an adhesive may be applied to the web at a designated area by an adhesive applicator 121. The adhesive is preferably a non-conductive adhesive, such as a non-conductive paste (NCP), or an anisotropic conductive paste (ACP). The adhesive/paste is preferably arranged for thermal compression bonding. The adhesive is preferably applied in liquid form, and cured/solidified when heated. The adhesive can, additionally or alternatively, be provided after placement of the IC, to provide additional strength to the joint.

In a second step, an IC/chip insertion station 122 is provided, where ICs/chips are inserted into the holes of the labels, thereby coming into contact with dedicated connection areas, i.e. connection pads, of the electrically conductive patterns of the labels. The insertion station may e.g. be a pick-and-place station, where ICs are picked from a storage, such as a stack, a container, a batch hopper, a wafer or the like and brought into the intended position on the labels. The picking tool may e.g. operate by vacuum. Heat is also preferably provided, in order to cure/solidify the adhesive, and also form adequate electric contact between the ICs and the electrically conductive patterns. Heat may e.g. be provided by heating of the picking tool, or by an external heater, e.g. arranged above or underneath the placement position. Additionally, or alternatively, the ICs may also be preheated during storage. Additionally, or alternatively, the conductive pattern may be heated prior to or during placement of the IC. Due to the heating, the IC will be soldered to contact areas of the conductive pattern. To ensure that electric contact is established between the ICs and the electrically conductive patterns, and also to facilitate placement of the ICs on the labels, the ICs may be provided with contact pads or bumps extending out from the IC body, and providing an enlarged and more easily connectable area.

In case the conductive pattern is made of a material with a high melting temperature, such as silver ink, grinded aluminum, nano-copper ink or the like, which is difficult or impossible to melt in the present context, the connection of the IC can instead be made solely by adhesive, such as NCP, ACP, ICP or other adhesive, arranged on the contact areas prior to placement of the IC.

The adhesive may also be cured, after placement of the IC. Curing can e.g. be obtained by heating, irradiation, etc. For example, a heated thermode for thermocompression curing of the adhesive can be used. Additionally, or alternatively, curing can be effected by e.g. heating in a heated oven, UV radiation, or the like.

In a third step, a programming and/or testing station 123 may be provided. The IC circuit and the electrically conductive pattern may e.g. form an RFID transponder. At the programming and/or testing station 123, the RFID transponders may be programmed, in case they are not preprogrammed before placement on the labels, and the function of each RFID transponder may be tested and verified. The programming and/or testing station may comprise an interrogator system comprising an RFID antenna or multiple antenna arrays for checking and testing the functionality of each RFID transponder. More specifically, the station may comprise an RFID reader or an RFID reader/writer.

Thereafter, the completed labels with integrated electrically conductive patterns and ICs/chips connected thereto, e.g. in the form of RFID transponders, are re-winded onto a final label roll at a re-winding station 124.

In the above embodiment, the steps of inserting an IC/chip into the hole and conductively attaching the chip to the dedicated contact areas is performed as a separate process. However, these steps may also be integrated in the process of forming the labels, discussed above with reference to Fig. 1. For example, these steps may be performed after lamination of the webs, i.e. after the lamination nip 109, and prior to the re-winding, i.e. prior to re-winding station 113. Alternatively, the ICs/chips may be arranged on the face material web 200 and be connected to the electrically conductive patterns after the curing step, i.e. after the heater 104, but prior to lamination in the lamination nip 109. In this case, attachment and electrical contact between the ICs/chips and the electrically conductive patterns will be established during the lamination step or in a prior or subsequent additional heating and/or pressing step.

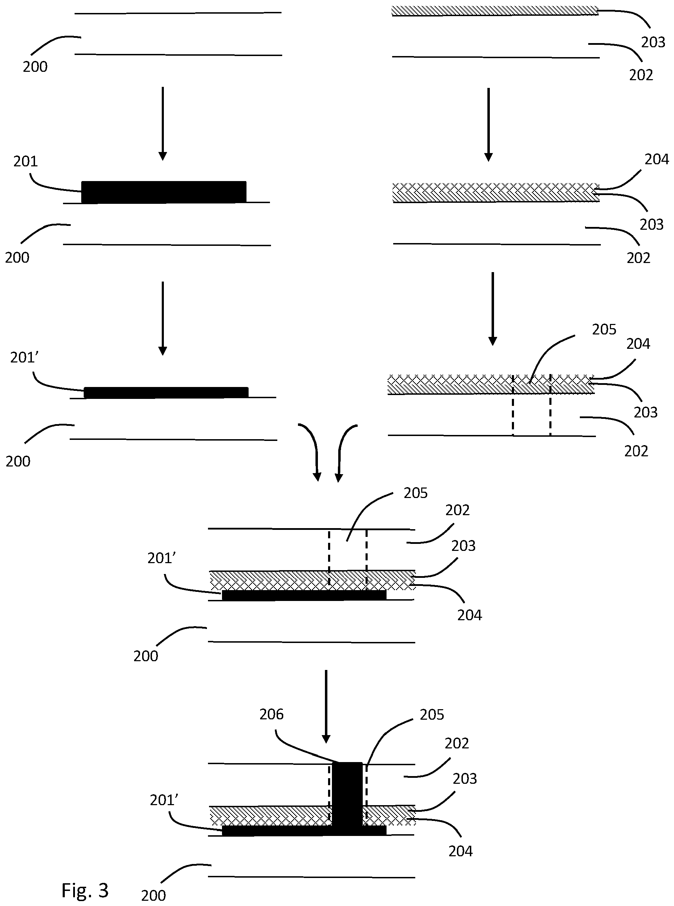

A shown schematically at the left hand side of Fig. 3, a first material web, the face material web 200, e.g. made of paper, is first provided. This is the material being inserted at insertion station 101. Thereafter, the conductive material 201, e.g. in the form of solid particles, is transferred to a surface of the material 200. The conductive material 201 is then cured and solidified in the heating/sintering device 104, resulting in a solidified electrically conductive pattern 201'.

As shown at the right-hand side of Fig. 3, a backing material web 202, e.g. made of paper, is first provided. This is the material being inserted at insertion station 105. The backing material web may also, optionally, be siliconized, and comprise a layer of silicone 203. Thereafter, the adhesive layer 204 is applied on top of the backing material web 202, and the silicone layer 203 (if present) in the adhesive applicator 107. Holes 205 may then be punched or cut through the web, in the punching station 108.

As shown in the lower part of Fig. 3, the face material web and the backing material web are then brought together and laminated by the lamination nip 109. The resulting label will then have a face material web 200 at one side and a backing material web 202 at the other side, and in between an electrically conductive pattern 201' arranged closest to the face material web 200, and an adhesive layer 204 extending over the surface of the face material web and the electrically conductive pattern, except where the holes 205 are situated. The holes form access openings to dedicated contact areas of the electrically conductive patterns.

Thereafter, or previously in the process, as discussed above, integrated circuits 206 are arranged in the holes 205, and attached and electrically connected to the electrically conductive patterns 201'.

Specific embodiments of the invention have now been described. However, several alternatives are possible, as would be apparent for someone skilled in the art. For example, various ways of providing the transfer and curing of the conductive material for obtaining the electrically conductive pattern is feasible. Further, the electrically conductive pattern may function as an antenna, and e.g. a dipole antenna, but may also be used in other ways. Further, lamination may be obtained by use of a pressure sensitive adhesive, and application of a pressure to the webs to be laminated, but other ways of laminating the webs are also feasible. Further, placement and attachment of an integrated circuit to the electrically conductive pattern can be provided as integrated steps in the process of forming the labels, but may alternatively be provided in a separate process, or even be omitted. Such and other obvious modifications must be considered to be within the scope of the present invention, as it is defined by the appended claims. It should be noted that the above-mentioned embodiments illustrate rather than limit the invention, and that those skilled in the art will be able to design many alternative embodiments without departing from the scope of the appended claims. In the claims, any reference signs placed between parentheses shall not be construed as limiting to the claim. The word "comprising" does not exclude the presence of other elements or steps than those listed in the claim. The word "a" or "an" preceding an element does not exclude the presence of a plurality of such elements. Further, a single unit may perform the functions of several means recited in the claims.

## Claims

1. A method for forming a label with an electrically conductive pattern (201') in a roll-to-roll process, comprising the steps:
providing a first roll (102) of a face material web (200);
forming a conductive material (201) in a pattern corresponding to said electrically conductive pattern (201') on a surface of the face material web;
providing a second roll (106) of a backing material web (202);
applying a layer of adhesive (204) on a surface of the backing material web;
forming holes (205) in the backing material web, before or after said application of adhesive;
bringing the backing material web and the face material web together, so that the conductive material and the adhesive are facing each other, between the face material web and the backing material web, and whereby the holes are arranged overlying dedicated contact areas formed in the electrically conductive pattern;
laminating the face sheet material with the electrically conductive pattern and the backing sheet material with the adhesive together; and
re-winding the laminated web on a third roll (113).

2. The method of claim 1, wherein the face material (200) comprises at least one of: paper, board, polymer film, textile and non-woven material.

3. The method of claim 1 or 2, wherein the conductive material (201) is in the form of electrically conductive solid particles.

4. The method of any one of the preceding claims, wherein the forming of the conductive material (201) in a pattern (201') comprises:
transferring a conductive material (201) in a pattern (201') corresponding to said electrically conductive pattern to a surface of the face material web (200); and
heating the conductive material to a temperature exceeding a characteristic melting temperature of the conductive material.

5. The method of claim 4, wherein the transferring of conductive material (201) to the face material web (200) comprises direct printing of electrically conductive particles as a part of a compound that contains, in addition of the electrically conductive solid particles, a fluid or gelatinous substance.

6. The method of claim 4 or 5, further comprising a step of applying a pressure onto the heated conductive material (201) prior to lamination.

7. The method of claim 6, wherein pressure is applied by a nip, wherein the surface temperature of the nip is lower than said characteristic melting temperature.

8. The method of any one of the preceding claims, wherein the backing material (202) comprises at least one of: paper, board, polymer film, textile and non-woven material.

9. The method of any one of the preceding claims, wherein the adhesive (204) is a pressure sensitive adhesive.

10. The method of any one of the preceding claims, wherein the lamination is made by compressing the face material web (200) with the electrically conductive pattern (201) and the backing material web (202) with the adhesive (204) together by a lamination nip (109).

11. The method of any one of the preceding claims, further comprising the step of inserting a chip (206) into the hole (205) and conductively attaching the chip to the dedicated contact areas.

12. The method of any one of the preceding claims, wherein the electrically conductive pattern (201') forms an antenna.

13. The method of any one of the preceding claims, further comprising providing an additional layer of adhesive on an outer surface of the laminated web, useable to adhere the label to packages, containers and the like, and providing an easily removable release liner to cover the additional layer of adhesive.

14. An arrangement for forming a label with an integrated electrically conductive pattern (201) in a roll-to-roll process, comprising:
a first input station for receiving a first roll (102) of a face material web (200);
a pattern forming station for forming a conductive material (201) in a pattern corresponding to said electrically conductive pattern (201') on a surface of the face material web;
a second input station for receiving a second roll (106) of a backing material web (202);
an adhesive applicator (107) providing a layer of adhesive (204) on a surface of the backing material web (202);
a hole forming station for forming holes (205) in the backing material web, before or after said application of adhesive;
a laminating nip (109) laminating the face material web and the backing material web together, with the electrically conductive pattern and the adhesive arranged between the face material web and the backing material web, and with the holes arranged overlying dedicated contact areas formed in the electrically conductive pattern; and
a re-winding station (112) for re-winding the laminated web on a third roll (113).

15. The arrangement of claim 14, wherein the pattern forming station comprises a particle handler (103) for transferring a conductive material (201) in a pattern corresponding to said electrically conductive pattern (201') to a surface of the face material web (200); and
a heater (104) for heating the conductive material to a temperature exceeding a characteristic melting temperature of the conductive material.

## Patentansprüche

1. Verfahren zum Ausbilden eines Etiketts mit einer elektrisch leitenden Struktur (201') in einem Rolle-zu-Rolle-Prozess, die folgenden Schritte umfassend:
Bereitstellen einer ersten Rolle (102) einer Obermaterialbahn (200);
Ausbilden eines leitenden Materials (201) zu einer Struktur, die der elektrisch leitenden Struktur (201') entspricht, auf einer Oberfläche der Obermaterialbahn;
Bereitstellen einer zweiten Rolle (106) einer Trägermaterialbahn (202);
Aufbringen einer Schicht aus Klebstoff (204) auf eine Oberfläche der Trägermaterialbahn;
Ausbilden von Löchern (205) in der Trägermaterialbahn vor oder nach dem Aufbringen von Klebstoff;
Zusammenbringen der Trägermaterialbahn und der Obermaterialbahn, so dass das leitende Material und der Klebstoff einander zwischen der Obermaterialbahn und der Trägermaterialbahn zugewandt sind, und wodurch die Löcher so angeordnet werden, dass sie über dafür vorgesehenen Kontaktbereichen liegen, die in der elektrisch leitenden Struktur ausgebildet sind;
Aneinanderlaminieren der Obermaterialbahn mit der elektrisch leitenden Struktur und der Trägermaterialbahn mit dem Klebstoff; und
Wiederaufwickeln der laminierten Bahn auf eine dritte Rolle (113).

2. Verfahren nach Anspruch 1, wobei das Obermaterial (200) mindestens eines umfasst von: Papier, Pappe, Polymerfolie, Gewebe und Vliesmaterial.

3. Verfahren nach Anspruch 1 oder 2, wobei das leitende Material (201) die Form von elektrisch leitenden festen Teilchen aufweist.

4. Verfahren nach einem der vorangehenden Ansprüche, wobei das Ausbilden des leitenden Materials (201) zu einer Struktur (201') umfasst:
Übertragen eines leitenden Materials (201) mit einer Struktur (201'), die der elektrisch leitenden Struktur entspricht, auf eine Oberfläche der Obermaterialbahn (200); und
Erwärmen des leitenden Materials auf eine Temperatur, die eine charakteristische Schmelztemperatur des leitenden Materials übersteigt.

5. Verfahren nach Anspruch 4, wobei das Übertragen von leitendem Material (201) auf die Obermaterialbahn (200) ein direktes Drucken von elektrisch leitenden Teilchen als Teil einer Mischung, die zusätzlich zu den elektrisch leitenden festen Teilchen ein Fluid oder eine gallertartige Substanz enthält, umfasst.

6. Verfahren nach Anspruch 4 oder 5, ferner einen Schritt des Aufbringens von Druck auf das erwärmte leitende Material (201) vor der Laminierung umfassend.

7. Verfahren nach Anspruch 6, wobei Druck durch einen Klemmspalt aufgebracht wird, wobei die Oberflächentemperatur des Klemmspalts niedriger ist als die charakteristische Schmelztemperatur.

8. Verfahren nach einem der vorangehenden Ansprüche, wobei das Trägermaterial (202) mindestens eines umfasst von: Papier, Pappe, Polymerfolie, Gewebe und Vliesmaterial.

9. Verfahren nach einem der vorangehenden Ansprüche, wobei der Klebstoff (204) ein Haftkleber ist.

10. Verfahren nach einem der vorangehenden Ansprüche, wobei die Laminierung durch Aneinanderdrücken der Obermaterialbahn (200) mit der elektrisch leitenden Struktur (201) und der Trägermaterialbahn (202) mit dem Klebstoff (204) durch einen Laminier-Walzenspalt (109) vorgenommen wird.

11. Verfahren nach einem der vorangehenden Ansprüche, ferner den Schritt des Einbringens eines Chips (206) in das Loch (205) und des leitenden Anbringens des Chips an den vorgesehenen Kontaktbereichen umfassend.

12. Verfahren nach einem der vorangehenden Ansprüche, wobei die elektrisch leitende Struktur (201') eine Antenne bildet.

13. Verfahren nach einem der vorangehenden Ansprüche, ferner ein Bereitstellen einer zusätzlichen Klebstoffschicht auf einer Außenfläche der laminierten Bahn umfassend, die zum Kleben des Etiketts an Verpackungen, Behältern und dergleichen verwendbar ist, und Bereitstellen einer leicht entfernbaren Abziehfolie, um die zusätzliche Klebstoffschicht abzudecken.

14. Anordnung zum Ausbilden eines Etiketts mit einem integrierten elektrisch leitenden Struktur (201) in einem Rolle-zu-Rolle-Prozess, umfassend:
eine erste Eingabestation zum Empfangen einer ersten Rolle (102) einer Obermaterialbahn (200);
eine Strukturausbildungsstation zum Ausbilden eines leitenden Materials (201') zu einer Struktur, die der elektrisch leitenden Struktur (201') entspricht, auf einer Oberfläche der Obermaterialbahn;
eine zweite Eingabestation zum Empfangen einer zweiten Rolle (106) einer Trägermaterialbahn (202);
einen Klebstoffapplikator (107), der eine Klebstoffschicht (204) auf einer Oberfläche der Trägermaterialbahn (202) bereitstellt;
Lochbildungsstation zum Ausbilden von Löchern (205) in der Trägermaterialbahn vor oder nach dem Aufbringen eines Klebstoffs;
einen Laminier-Walzenspalt (109), der die Obermaterialbahn und die Trägermaterialbahn aneinanderlaminiert, wobei die elektrisch leitende Struktur und der Klebstoff zwischen der Obermaterialbahn und der Trägermaterialbahn angeordnet sind, und wobei die Löcher so angeordnet sind, dass sie über vorgesehenen Kontaktbereichen liegen, die in der elektrisch leitenden Struktur ausgebildet sind; und
eine Wiederaufwickelstation (112) zum Wiederaufwickeln der laminierten Bahn auf eine dritte Rolle (113).

15. Anordnung nach Anspruch 14, wobei die Strukturausbildungsstation eine Teilchenhandhabungseinrichtung (103) umfasst, zum Übertragen eines leitenden Materials (201) mit einer Struktur, die der elektrisch leitenden Struktur (201') entspricht, auf eine Oberfläche der Obermaterialbahn (200); und
eine Heizeinrichtung (104) zum Erwärmen des leitenden Materials auf eine Temperatur, die eine charakteristische Schmelztemperatur des leitenden Materials übersteigt.

## Revendications

1. Procédé pour former une étiquette avec un motif (201') électroconducteur dans un processus de rouleau à rouleau, comprenant les étapes suivantes :
la fourniture d'un premier rouleau (102) d'une bande de matériau de face (200) ;
la fourniture d'un matériau (201) conducteur en un motif correspondant audit motif (201') électroconducteur sur une surface de la bande de matériau de face ;
la fourniture d'un deuxième rouleau (106) d'une bande de matériau de renfort (202) ;
l'application d'une couche d'adhésif (204) sur une surface de la bande de matériau de renfort ;
la formation de trous (205) dans la bande de matériau de renfort, avant ou après ladite application d'adhésif ;
l'assemblage de la bande de matériau de renfort et de la bande de matériau de face, de telle sorte que le matériau conducteur et l'adhésif se font face, entre la bande de matériau de face et la bande de matériau de renfort, et moyennant quoi les trous sont agencés sus-jacents de zones de contact dédiées formées dans le motif électroconducteur ;
la stratification conjointe du matériau de feuille de face avec le motif électroconducteur et du matériau de feuille de renfort avec l'adhésif ; et
le réenroulage de la bande stratifiée sur un troisième rouleau (113).

2. Procédé selon la revendication 1, dans lequel le matériau de face (200) comprend au moins un parmi : du papier, du carton, un film polymère, un textile et un matériau non tissé.

3. Procédé selon la revendication 1 ou la revendication 2, dans lequel le matériau (201) conducteur se présente sous la forme de particules solides électroconductrices.

4. Procédé selon l'une quelconque des revendications précédentes, dans lequel la formation du matériau (201) conducteur en un motif (201') comprend :
le transfert d'un matériau (201) conducteur en un motif (201') correspondant audit motif électroconducteur sur une surface de la bande de matériau de face (200) ; et
le chauffage du matériau conducteur à une température dépassant une température de fusion caractéristique du matériau conducteur.

5. Procédé selon la revendication 4, dans lequel le transfert du matériau (201) conducteur sur la bande de matériau de face (200) comprend l'impression directe de particules électroconductrices faisant partie d'un composé qui contient, en plus des particules solides électroconductrices, une substance fluide ou gélatineuse.

6. Procédé selon la revendication 4 ou la revendication 5, comprenant en outre une étape d'application d'une pression sur le matériau (201) conducteur chauffé avant la stratification.

7. Procédé selon la revendication 6, dans lequel la pression est appliquée par un rouleau pinceur, dans lequel la température de surface du rouleau pinceur est inférieure à ladite température de fusion caractéristique.

8. Procédé selon l'une quelconque des revendications précédentes, dans lequel le matériau de renfort (202) comprend au moins un parmi : du papier, du carton, un film polymère, un textile et un matériau non tissé.

9. Procédé selon l'une quelconque des revendications précédentes, dans lequel l'adhésif (204) est un adhésif sensible à la pression.

10. Procédé selon l'une quelconque des revendications précédentes, dans lequel la stratification est réalisée en comprimant conjointement la bande de matériau de face (200) avec le motif (201) électroconducteur et la bande de matériau de renfort (202) avec l'adhésif (204) par un rouleau pinceur (109) de stratification.

11. Procédé selon l'une quelconque des revendications précédentes, comprenant en outre l'étape d'insertion d'une puce (206) dans le trou (205) et de fixation conductrice de la puce aux zones de contact dédiées.

12. Procédé selon l'une quelconque des revendications précédentes, dans lequel le motif (201') électroconducteur forme une antenne.

13. Procédé selon l'une quelconque des revendications précédentes, comprenant en outre la fourniture d'une couche supplémentaire d'adhésif sur une surface externe de la bande stratifiée, utilisable pour coller l'étiquette à des emballages, des contenants et analogues, et la fourniture d'une doublure antiadhérente amovible pour recouvrir la couche supplémentaire d'adhésif.

14. Agencement pour former une étiquette avec un motif (201) électroconducteur intégré dans un processus de rouleau à rouleau, comprenant :
une première station d'entrée pour recevoir un premier rouleau (102) d'une bande de matériau de face (200) ;
une station de formation en motif pour former un matériau (201) conducteur en un motif correspondant audit motif (201') électroconducteur sur une surface de la bande de matériau de face ;
une deuxième station d'entrée pour recevoir un deuxième rouleau (106) d'une bande de matériau de renfort (202) ;
un applicateur (107) d'adhésif fournissant une couche d'adhésif (204) sur une surface de la bande de matériau de renfort (202) ;
une station de formation de trous pour former des trous (205) dans la bande de matériau de renfort, avant ou après ladite application d'adhésif ;
un rouleau pinceur (109) de stratification stratifiant conjointement la bande de matériau de face et la bande de matériau de renfort, avec le motif électroconducteur et l'adhésif agencés entre la bande de matériau de face et la bande de matériau de renfort, et avec les trous agencés sus-jacents de zones de contact dédiées formées dans le motif électroconducteur ; et
une station (112) de réenroulement pour réenrouler la bande stratifiée sur un troisième rouleau (113).

15. Agencement selon la revendication 14, dans lequel la station de formation en motif comprend un manipulateur (103) de particules pour transférer un matériau (201) conducteur en un motif correspondant audit motif (201') électroconducteur sur une surface de la bande de matériau de face (200) ; et
un dispositif (104) de chauffage pour chauffer le matériau conducteur à une température dépassant une température de fusion caractéristique du matériau conducteur.
